Europäisches Patentamt

European Patent Office

Office européen des brevets

(11) Veröffentlichungsnummer: **0 080 756**
**A1**

## (12) EUROPÄISCHE PATENTANMELDUNG

(21) Anmeldenummer: 82201456.9

(22) Anmeldetag: 17.11.82

(51) Int. Cl.³: **H 05 K 3/36**
**H 05 K 7/06**

(30) Priorität: 26.11.81 CH 7559/81

(43) Veröffentlichungstag der Anmeldung:
08.06.83 Patentblatt 83/23

(84) Benannte Vertragsstaaten:
AT BE CH DE FR GB IT LI LU NL SE

(71) Anmelder: Autophon A.G.
Ziegelmattstrasse 1-15
CH-4500 Solothurn 3(CH)

(72) Erfinder: Anderegg, Fredy
Friedhofstrasse 365
CH-4573 Lohn(CH)

(72) Erfinder: Furrer, Josef
Dahlienweg 1
CH-4708 Luterbach(CH)

(72) Erfinder: Däppen, Heinz
Dorfstrasse 4
CH-4534 Flumenthal(CH)

(74) Vertreter: Schweizer, Hans et al,
Bovard AG Patentanwälte VSP Optingenstrasse 16
CH-3000 Bern 25(CH)

(54) Mehrteilige Leiterplatte mit auf maschinelle Weise verlegten Drähten und Verfahren zu deren Herstellung.

(57) In einer Leiterplatte mit maschinell verlegten Drähten (14) sind einzelne Bereiche aus zwei parallel laufenden Polyimid-Folien (9, 12) gebildet, wodurch die Platte in jenem Bereich beweglich ist. Die Ränder dieser Folien (9, 12) sind im Bereich der Ränder der starren Teile (3) der Leiterplatte mit durch Wärme aktivierbarem Kleber (6, 16) festgehalten. In den beweglichen Bereichen sind die Drähte (14) in eine zwischen die beiden Polyimid-Folien eingefügte, durch Wärme aktivierbare Kleberschicht (10) eingebettet, wobei diese Kleberschicht - im Gegensatz zu den Kleberschichten (11, 13) auf den starren Teilen - kein Gewebe enthält.

EP 0 080 756 A1

- 1 -

Mehrteilige Leiterplatte mit auf maschinelle Weise
verlegten Drähten und Verfahren zu deren Herstellung

Es sind aus einem starren Material bestehende Leiterplatten bekannt, auf denen mindestens zwei Schichten aus einem durch Wärme aktivierbaren Kleber angebracht sind und bei denen eine maschinell verlegte isolierte Verdrahtung in die eine Kleberschicht eingebettet und mit der andern zugedeckt ist. Solche unter dem Namen "Multiwire" bekannten Leiterplatten bieten gegenüber gewöhnlichen Leiterplatten den Vorteil, dass Drahtkreuzungen möglich sind, eine höhere Packungsdichte der montierten Bauelemente zu erreichen ist und die einmaligen Vorbereitungsarbeiten zur Herstellung einer Serie kleiner sind.

Entsprechend gewöhnlichen Leiterplatten ist es auch bei verdrahteten Leiterplatten notwendig, die Wände der Löcher zu verkupfern, damit einerseits die in die Löcher gesteckten Anschluss-Drähte der auf der Platte anzubringenden Bauteile richtig verlötet und anderseits verschiedene Lagen von Leitern über die Löcher verbunden werden können. Das Anbringen einer solchen Verkupferung ist jedoch bei verdrahteten Leiterplatten schwieriger als bei gewöhnlichen. Die gewöhnlichen Leiterplatten werden vor der Herstellung des Leiterbildes mit Löchern versehen und in ein Bad verbracht, aus welchem auf rein chemischem Wege ein sehr dünner Kupfer-Niederschlag abgeschieden wird. Der Niederschlag in den Löchern wird anschliessend auf galvanische Weise verstärkt.

- 2 -

Eine solche galvanische Verstärkung kann bei Leiterplatten mit maschinell angebrachten Drähten nicht angewendet werden. Der Kupferbelag auf den Lochwandungen wird dort hergestellt, indem in das Material der Platte und der darauf angebrachten Kleberschichten ein Katalysator eingeschlossen wird, welcher im Zusammenwirken mit einem geeigneten Bad ermöglicht, ohne Verwendung von Elektrizität auf rein chemische Weise Kupfer in genügender Dicke abzuscheiden. Durch geeignetes Abdecken der Platte wird dabei die Verkupferung auf die Löcher beschränkt.

Es sind bewegliche "gedruckte Schaltungen" bekannt geworden, die mit starren Leiterplatten derart kombiniert werden können, dass ohne Anwendung von Lötstellen oder Steckern die Herstellung von mehrteiligen Leiterplatten mit starren und dazwischen liegenden beweglichen Teilen möglich ist. Solche Leiterplatten sind beispielsweise aus der deutschen Offenlegungsschrift 26 57 212 bekannt geworden. Bei den dort beschriebenen Platten verlaufen geätzte Leiterbahnen unterbruchslos über starre und bewegliche Teile. Bei deren Herstellung wird von einer allgemein bekannten beweglichen "gedruckten Schaltung" ausgegangen, bei welcher auf einer vorzugsweise aus Polyimid bestehenden Folie ein- oder beidseitig durch Aetzen hergestellte und durch weitere Folien zugedeckte Leiterbahnen angebracht sind. Einzelne Zonen einer solchen beweglichen Schaltung werden nun auf oder zwischen starre Leiterplatten geklebt, und die Leiterbahnen beider Arten von Schaltungen werden untereinander durch verkupferte Löcher verbunden.

- 3 -

Es scheint naheliegend zu sein, die bekannte Technik auch für Leiterplatten anzuwenden, in denen maschinell verlegte Drähte eingebettet sind. Einem solchen Vorhaben steht jedoch entgegen, dass einerseits die für die beweglichen Teile in Frage kommenden Polyimid-Folien keinen Katalysator enthalten und dass anderseits das für das Einbetten der Drähte bis jetzt verwendete Material zu wenig beweglich ist. Dieses Material, an welches besondere Anforderungen gestellt werden, indem die Drähte daran angeklebt, darin eingebettet und ausserdem gegen seitliche Verschiebung gesichert werden sollen und indem dessen Oberfläche ermöglichen soll, dass einerseits die Drähte beim Verlegen gut daran haften und sich anderseits ein gut haftender Kupferbelag daran bilden kann, enthält ein Glasfasergewebe, welches in erster Linie den beschriebenen Nachteil bewirkt.

Polyimid-Folien können daher in den starren Teilen, wo Löcher mit verkupferten Wänden angebracht werden müssen, nicht verwendet werden, während das Material, in welchem in den starren Platten die Drähte eingebettet werden im beweglichen Teil nicht anwendbar ist.

Die vorliegende Erfindung geht nun von der Erkenntnis aus, dass im beweglichen Teil keine Löcher gebohrt werden müssen und dass an das Material für die beweglichen Teile viel weniger Anforderungen gestellt werden müssen als für das entsprechende Material auf den starren Teilen. Daraus folgt, dass für die beweglichen Teile andere Materialien als für die starren Teile verwendet werden können, sofern sich die Verwendung dieser Materialien auf die beweglichen Teile beschränkt. In den beweglichen Bereichen können somit als Trägermaterial Polyimid-Folien und zur Einbettung der Drähte Materialien verwendet werden, welche ausser Beweglichkeit nur noch die Forderung

- 4 -

erfüllen müssen, dass die Drähte beim Verlegen einigermassen daran haften.

Für die Schaffung einer mehrteiligen, starre und bewegliche Bereiche aufweisenden Leiterplatte mit maschinell verlegten Drähten stellt sich somit die Aufgabe, die starren und die beweglichen Teile aus verschiedenen Materialien aufzubauen und trotzdem eine über die verschiedenen Teile verlaufende zusammenhängende Verdrahtung zu ermöglichen. Mit der vorliegenden Erfindung wird diese Aufgabe gelöst.

Die Erfindung betrifft eine mehrteilige Leiterplatte nach dem Oberbegriff des Patentanspruchs 1, welche dadurch gekennzeichnet ist, dass die beweglichen Teile je eine untere und eine obere ausschliesslich zwischen den starren Teilen verlaufende und in Randzonen der starren Teile befestigte nicht klebende bewegliche Folie umfassen. Ein weiteres Kennzeichen der Erfindung besteht darin, dass Drähte vorhanden sind, welche unterbruchslos von einem starren Teil über einen beweglichen Teil nach dem benachbarten starren Teil verlaufen und dabei im beweglichen Teil in einer zwischen die beiden nicht-klebenden Folien eingefügte, die beiden Folien verbindende und aus einem durch Wärme aktivierbaren faserfreien Kleber bestehende dritte Schicht eingebettet sind.

In einer besondern Ausführungsform der Erfindung sind in den genannten Randzonen weitere Kleberschichten angebracht, um die Ränder der nicht-klebenden Folien zu befestigen.

Die Erfindung betrifft auch ein Verfahren zur Herstellung einer mehrteiligen Leiterplatte der beschriebenen Art.

- 5 -

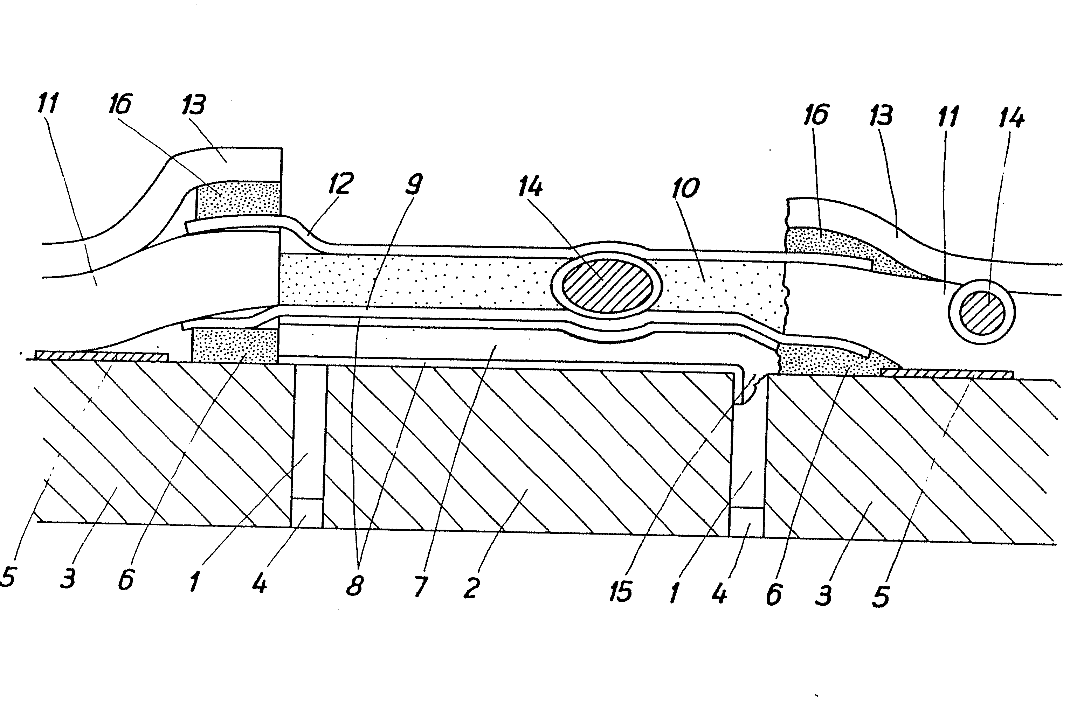

Die Erfindung wird nun anhand eines Ausführungsbeispiels erklärt. Die Figur zeigt einen Querschnitt durch eine dreiteilige Leiterplatte in einer der letzten Herstellungsphasen. Der Massstab für die Dicken der Schichten ist dabei ungefähr 20 mal grösser gewählt als derjenige für die Längen, ausgenommen bei der Darstellung der Drähte. Die Drähte, die senkrecht zur Bildebene verlaufen, sind rund, diejenigen, die parallel zur Bildebene verlaufen und deshalb nicht richtig darstellbar wären, sind schräg geschnitten dargestellt. Deren ovale Form lässt deshalb nicht, wie fälschlicherweise vermutet werden könnte, auf eine Deformation dieser Drähte schliessen. Die Schichten sind auf der linken Seite der Figur so dargestellt, wie sie im unverpressten Zustand aufeinanderliegen. Die rechte Seite zeigt die Verhältnisse nach dem Verpressen.

Die Figur zeigt eine starre Platte aus glasfaserverstärktem Epoxi-Material, welche durch Einschnitte 1 in den innern Bereich 2 und die äussern Bereiche 3 unterteilt ist. Die Einschnitte sind abgesehen von Stegen 4, durchgehend. Die Plattenteile 2 und 3 werden vorderhand mit diesen Stegen zusammengehalten, sind jedoch durch Abbrechen leicht trennbar. Die beiden äussern Teile 3 der Platte bleiben als starre Leiterplatten bestehen, während der mittlere Teil 2 später entfernt wird.

Die Teile 3 weisen ein in herkömmlicher Art durch Aetzen aufgebrachtes Leiterbild 5 auf, welches in erster Linie zur Zufuhr von Speisung und zur Verbindung mit Masse dient und welches mit den in der Folge beschriebenen Vorgängen und Anordnungen nichts zu tun hat.

Die Bereiche 3 der Platte, mit welchem die starren Teile gebildet werden, sind grundsätzlich je mit einer ersten Schicht 11 aus einem Materialgemisch, welches zur Aufnahme von darin eingebetteten Drähten 14 geeignet ist und mit einer zweiten Schicht 13 als Abdeckmaterial, welche unter der Bezeichnung "Prepreg" bekannt ist, versehen. Dieser Aufbau entspricht einer normalen starren Leiterplatte mit eingelegten Drähten. Beide Schichten enthalten ein Glasfasergewebe und einen durch Wärme aktivierbaren Kleber aus Epoxy-Harz. Das Glasfasergewebe in der ersten Schicht verhindert dabei seitliche Verschiebungen der Drähte, und die besondere Zusammensetzung ermöglicht die einwandfreie Verkupferung von (nicht dargestellten) Löchern und die Verbindung der betreffenden Kupferschicht mit den durch die Löcher angeschnittenen Drähten.

Zwischen die Grundplatte und die erste Schicht und zwischen die erste und die zweite Schicht ist nun im Bereich einer Randzone je eine nicht-klebende Folie 9 und 12 aus Polyimid "Kapton" eingefügt. Diese Folien werden innerhalb der Randzonen von den beiden Klebschichten 6 und 16 mit der Platte 3 bzw. mit der zweiten Schicht 13 verbunden. Diese Klebschichten bestehen ebenfalls aus durch Wärme aktivierbarem Material, vorzugsweise aus dem Acrylat-Material "Pyralux LF 0100".

Durch das Verkleben der Polyimid-Folien 9 und 12 mit Hilfe der beiden Streifen 6 und 16 und dank dem in den Schichten 11 und 13 enthaltenen Glasfasergewebe weist die Verbindung der Folien 9 und 12 mit den Platten 3 eine hohe Festigkeit auf.

Die beiden Polyimid-Folien 9 und 12 sind durch einen faserfreien, durch Wärme aktivierbaren Kleber 10 verklebt. Dieser Kleber mit der Markenbezeichnung "Scotch-Weld 588" wird üblicherweise verwendet, um Brems- und Kupplungsbeläge oder Schilder auf eine Unterlage zu kleben.

In die Schichten 11 und 10 sind maschinell verlegte Drähte 14 eingebettet, welche von der einen starren Platte 3 unterbruchslos über den aus den Folien 9 und 12 und der dazwischen liegenden Kleberschicht 10 bestehenden beweglichen Teil nach der andern starren Platte 3 verlaufen und damit unlösbar mit allen drei Teilen der Leiterplatte verbunden sind.

Die Folie 7, 8 wird nur während der Herstellung der Leiterplatte benötigt und wird später in diesem Zusammenhang erklärt.

Bei der Herstellung einer Leiterplatte gemäss der Figur werden zuerst die Einschnitte 1 in die Grundplatte gefräst, so dass nur noch die Stege 4 als Verbindung zwischen den Teilen 2 und 3 verbleiben. Sodann wird in konventioneller Art das Leiterbild 5 aufgebracht.

Auf den Mittelteil 2 wird eine Verbund-Folie aufgelegt, welche aus zwei nicht-klebenden Trennfolien 8 mit einer dazwischen liegenden Thermoplast-Schicht 7 besteht. Diese unter dem Markennamen "Contiflex Conformal Coating" bekannte Folie dient normalerweise für das Verpressen von unebenen geschichteten Gebilden. Die Abmessungen dieser Verbund-Folie werden derart gewählt, dass die Folie die Einschnitte 1 vollständig verdeckt und noch ein kleines Stück darüber hinaus reicht. Da die Trennfolie 8 bei den später beschriebenen Vorgängen mit der "Kapton"-Folie 9 verkleben kann, empfiehlt es sich, auf die Verbund-Folie 7, 8 eine nicht dargestellte weitere Trennfolie ("Tedlar") aufzulegen.

Sodann wird die untere Polyimid-Folie 9 derart auf den Mittelteil 2 aufgelegt, dass sie die Ränder der Folie 7,8 ungefähr 5 mm überragt. Zwischen diesem überragenden Teil der Folie 9 und der Platte 3 wird ein Klebstreifen 6 aus dem Acrylat-Material "Pyralux LF 0100" angebracht. Dieses faserfreie und durch Wärme aktivierbare Klebematerial wird üblicherweise verwendet, um bei konventionellen flexiblen Leiterplatten die auch dort angewendeten "Kapton"-Folien auf eine starre Unterlage zu kleben oder um zwei "Kapton"-Folien miteinader zu verbinden.

Der Streifen 6 wird vor dem Verlegen der Folie 9 durch punktweises Erwärmen zum Beispiel mit einem Lötkolben provisorisch auf der Platte 3 oder auf der Folie 9 befestigt.

Auf die Polyimid-Folie 9 wird eine in ihren Abmessungen und ihrer Lage der Verbund-Folie 7, 8 entsprechende faserfreie und durch Wärme aktivierbare Kleberfolie 10 ("Scotch-Weld") aufgelegt. Je eine bei verdrahteten Leiterplatten zur Aufnahme der Drähte bestimmte, ein Glasfaser-Gewebe enthaltende und ebenfalls durch Wärme aktivierbare Kleber-Folie 11 wird nun derart auf die Bereiche 3 aufgelegt, dass die Ränder der Folien 10 und 11 aneinander anstossen.

Die aufgelegten Folien werden, um gegenseitige Verschiebungen zu vermeiden, jeweils teils durch punktweises Erwärmen, teils durch doppelseitige Klebebänder bis zum nächsten Verarbeitungsschritt behelfsmässig festgeklebt.

Das bisher zusammengestellte Paket wird nun, unter Verwendung geeigneter elastischer und Klebstoff abstossender Unterlagen, bei einer Temperatur, bei welcher die durch Wärme aktivierbaren Schichten gerade zu fliessen beginnen, verpresst. Die wegen der verschiedenen Dicke der Folien 10 und 11 vorhandene Sprungstelle wird dabei etwas ausgeglichen.

Sodann werden in einer an sich bekannten, jedoch mit der Erfindung nicht direkt in Beziehung stehenden maschinellen Weise in die Schichten 11 und 10 isolierte Drähte 14 verlegt. Dieses Verlegen geschieht durch Bewegung der Platte unter einem Presserfuss, wobei durch Vibration des Fusses mit Ultraschall-Frequenz infolge der dabei entstehenden Wärme die Drähte oberflächlich in die Schichten 11 und 10 eingebettet werden. Anfangs- und Endpunkt und der dazwischen liegende Verlauf werden dabei von einem Komputer gesteuert. In den Bereichen 3 verlaufen die Drähte parallel und senkrecht zur Bildebene und weisen Ueberkreuzungen auf, während im Mittelbereich 2 die Drähte ausschliesslich parallel zur Bildebene verlaufen.

Nach beendeter Verdrahtung wird über den mittleren Teil 2 die nicht-klebende Polyimid-Folie 12 gelegt, deren Ränder die darunter liegende Schicht 10 in gleicher Weise überragt, wie bei der Folie 9. Auf den überragenden Teilen der Folie 12 werden sodann den Streifen 6 entsprechende durch Wärme aktivierbare Klebstreifen 16 ("Pyralux") angebracht, wobei dies vor oder nach dem Verlegen der Folie 12 bewerkstelligt werden kann.

Zuletzt werden über den Platten-Bereichen 3 zwei mit Glasgewebe verstärkte, durch Wärme aktivierbare Folien 13 ("Prepreg") aufgelegt, deren Abmessungen und Lagen denjenigen der Folien 11 entsprechen.

Nachdem alle Folien angebracht sind, wird das ganze Paket zwischen geeigneten Kleber abstossenden und verformbaren Unterlagen ein zweites Mal unter Hitzeeinwirkung verpresst, wobei die verschiedenen aktivierbaren Schichten in ihren Endzustand übergehen und die Drähte so weit in ihre Unterlage eingebettet werden wie dies in der Figur dargestellt ist. Die in den Schichten 11 liegenden Drähte können dabei infolge der Wirkung der Gewebeeinlage durch das Pressen nicht verschoben werden, was wesentlich ist, wenn der Drahtverlauf genau zum Bild der später angebrachten Löcher passen soll. Die in der Kleberschicht 10 liegenden Drähte sind dagegen gegen Verschiebungen beim Pressen nicht gesichert, was aber kein Nachteil ist, da in jenem Bereich keine Löcher gebohrt werden. Der Gefahr, dass beim Verpressen die im Bereich der Einschnitte 1 im beweglichen Teil verlaufenden Drähte nach unten gedrückt werden und damit Schaden leiden, wird durch die Eigenschaften der Verbund-Folie 7, 8 vorgebeugt, indem beim

- 11 -

Verpressen unter Wärmewirkung in einer bei 15 gezeigten Weise thermoplastisches Material aus der Folie austritt, den Einschnitt zum Teil auffüllt und damit dem Durchbiegen der Schichten 9, 10 und 12 entgegenwirkt. Zur Beurteilung dieser Sachlage müssen dabei die für zwei Richtungen verschiedenen Massstäbe der Figur berücksichtigt werden.

In einer in der Figur nicht dargestellten Weise wird alsdann die beschriebene Platte mit einer weitern Folie überzogen, und es werden in den Bereichen 3 die vorgeschriebenen Löcher gebohrt, welche die Drähte 14 und die Kupferleiter 5 anschneiden. Wie schon früher erwähnt wurde, enthält das Material der Platte 3 und der Schichten 11 und 13 einen Katalysator, die genannte weitere Folie dagegen keinen. Wird nun die Platte in ein Bad getaucht, welches alles den Katalysator enthaltende Material verkupfert, wird ausschliesslich an den Lochwandungen Kupfer abgeschieden. Nach dem Verkupfern wird die zuletzt aufgebrachte Folie wiederum entfernt.

Anschliessend wird die Platte mit Bauelementen bestückt, indem die Anschlussdrähte der Elemente in die verkupferten Löcher eingeführt werden. Die Anschlüsse werden dann in bekannter Weise in einem Lötbad verlötet.

Sodann werden die Stege 4 gebrochen, worauf der mittlere Bereich 2 der Platte, samt der Verbund-Folie 7, 8 und gegebenenfalls der nicht dargestellten Trennfolie, entfernt werden kann. Damit besteht die Leiterplatte aus zwei starren, durch einen beweglichen Teil verbundenen Platten.

Die Erfindung ist natürlich nicht an das Ausführungsbeispiel gebunden. Es ist insbesondere anzunehmen, dass es ausser dem Material "Scotch-Weld 588" und "Pyralux LF 0100" noch andere durch Wärme aktivierbare Klebefolien gibt, welche die zur Ausführung der Erfindung geeigneten Eigenschaften besitzen und welche anstelle der genannten Materialien verwendet werden könnten. Anstelle des "Contiflex Conformal Coating" könnte ebenfalls ein anderes Material mit ähnlichen Eigenschaften verwendet werden.

Im Beispiel wurde eine dreiteilige Leiterplatte mit zwei starren Teilen und einem dazwischen liegenden beweglichen Teil angenommen. Es ist aber ohne weiteres möglich, mehr als zwei starre durch entsprechende dazwischen liegende bewegliche Teile zu verbinden. Die gegenseitige Anordnung der starren Teile und damit die Lage und Form der beweglichen Teile kann beliebig gewählt werden.

Sofern es notwendig ist, auf den starren Teilen eine derart vielfältige Verdrahtung anzubringen, dass eine einzige Schicht dazu nicht ausreicht, können in diesen Bereichen mit besondern Arbeitsgängen weitere verdrahtete Schichten (11) übereinander angebracht werden.

- 1 -

Patentansprüche

1. Mehrteilige Leiterplatte mit starren und beweglichen Teilen, bei welcher jeweils zwei starre Teile (3,11, 13) durch einen beweglichen Teil (9,12) verbunden sind, bei welcher ferner bei den starren Teilen je eine untere erste (11) und eine obere zweite (13), je ein Glasfasergewebe und einen durch Wärme aktivierbaren Kleber enthaltende Schicht auf einer starren Platte (3) angebracht sind und bei welcher in der ersten Schicht (11) maschinell verlegte Drähte (14) eingebettet sind, dadurch gekennzeichnet, dass die beweglichen Teile (9,12) je eine untere (9) und eine obere (12) ausschliesslich zwischen den starren Teilen (3,11,13) verlaufende und in Randzonen der starren Teile befestigte nicht klebende bewegliche Folie umfassen und dass Drähte (14) vorhanden sind, welche unterbruchslos von einem der starren Teile (3,11,13) über einen beweglichen Teil (9,12) nach dem benachbarten starren Teil (3,11,13) verlaufen und dabei im beweglichen Teil in einer zwischen die beiden nicht-klebenden Folien (9,12) eingefügte, die beiden Folien verbindende und aus einem durch Wärme aktivierbaren faserfreien Kleber bestehende dritte Schicht (10) eingebettet sind.

- 2 -

2. Leiterplatte nach dem Patentanspruch 1, bei welcher die genannten Randzonen durch eine gegenseitige Ueberlappung einerseits der untern Folie (9) und der genannten ersten Schicht (11) und anderseits zwischen der obern Folie (12) und der genannten ersten (11) und zweiten (13) Schicht gebildet sind, gekennzeichnet durch weitere, ausschliesslich in den genannten Randzonen vorhandene, durch Wärme aktivierbare Kleberschichten (16), welche einerseits zwischen der starren Platte (3) und unterer Folie (9) und anderseits zwischen oberer Folie (12) und der genannten zweiten Schicht (13) eingefügt sind.

3. Verfahren zur Herstellung einer mehrteiligen Leiterplatte gemäss Patentanspruch 1, in welchem Verfahren von einer einzigen starren Platte ausgegangen wird, welche in durch Einschnitte (1) abgegrenzte Bereiche entsprechend starren (3) und beweglichen (2) Teilen eingeteilt ist und aus welcher später in den den beweglichen Teilen entsprechenden Bereichen (2) das starre Material entfernt wird, gekennzeichnet durch die folgenden Verfahrensschritte:

- Auflegen je einer aus zwei Trennfolien (8) mit einer dazwischen liegenden thermoplastischen Mittelschicht (7) bestehenden Verbundfolie auf die Bereiche (2) für die beweglichen Teile

- Auflegen je einer nicht klebenden Folie (9) auf die Bereiche (2) für die beweglichen Teile, wobei diese Folien (9) die Verbundfolien (7,8) seitlich überragen und sich die überragenen Bereiche auf die Bereiche (3) der starren Teile erstrecken und wobei in den überragenden Bereichen je zwischen starrem Teil (3) und nicht-klebender Folie (9) eine durch Wärme aktivierbare Kleberfolie (6) angebracht wird

- Auflegen von einem durch Wärme aktivierbaren Kleber enthaltenden Folien, wobei Fasern enthaltende, der genannten ersten Schicht entsprechende Folien (11) auf die Bereiche (3) der starren Teile und faserlose Folien (10) auf die Bereiche (2) der beweglichen Teile aufgelegt werden

- Verkleben der aufgelegten Folien untereinander und mit Teilen der Platte durch Verpressen unter Wärmeeinwirkung

- 4 -

- Verlegen von Drähten (14) über alle Bereiche (3,2) hinweg, wobei die Drähte durch Ultraschall-Vibration in das Material eingedrückt werden

- Auflegen je einer nicht-klebenden Folie (12) auf die Bereiche (2) der beweglichen Teile, wobei diese Folie (9) die darunter liegende faserlose, Drähte enthaltende Schicht (10) seitlich überragt und sich die überragenden Bereiche auf die Bereiche (3) der starren Teile erstrecken

- Auflegen von der genannten zweiten Schicht entsprechenden, durch Wärme aktivierbaren Kleber und ein Gewebe enthaltenden Folien (13) auf die Bereiche (3) der starren Teile, wobei in den Bereichen, in welchen diese Folien (13) die nicht klebenden Folien (12) überlappen, je zwischen den beiden letztgenannten Folien (12,13) eine durch Wärme aktivierbare Kleberfolie (16) angebracht wird

- Zusammenkleben der seit dem letzten Verpressen aufgelegten Folien und vollständiges Einbetten der Drähte durch erneutes Verpressen unter Wärmeeinwirkung

- Bohren von Löchern, Verkupfern, Montieren der Elemente und Verlöten in gleicher Weise wie bei einteiligen starren Leiterplatten

- Entfernen des starren Materials in den Bereichen (2) der beweglichen Teile und Entfernen der Verbundfolie (7,8).

))) Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | GB-A-2 063 571 (KOLLMORGEN TECHNOLOGIES) | | H 05 K 3/36<br>H 05 K 7/06 |
| | --- | | |
| A | ELECTRONICS, Band 52, Nr. 26, Dezember 1979, Seiten 117-121, NEW YORK (US.).<br>G. MESSNER et al., "New Multiwire meets the challenge of interconnecting chip-carriers", Seite 118, Spalte 2, Absatz 2 - Seite 119, Spalte 1, Absatz 7; Abbildung 1 * | | |
| | --- | | |
| A | US-A-4 000 558 (I.T.T.) | | |
| | --- | | RECHERCHIERTE SACHGEBIETE (Int. Cl. ³) |
| A | FR-A-2 344 203 (COMMISSARIAT A L'ENERGIE ATOMIQUE) | | |
| | ----- | | H 05 K |

Der vorliegende Recherchenbericht wurde für alle Patentansprüche erstellt.

| Recherchenort<br>DEN HAAG | Abschlußdatum der Recherche<br>03-03-1983 | Prüfer<br>SCHUERMANS N.F.G. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82